# EUROPEAN PATENT APPLICATION

(11) **EP 3 121 969 A1**
(43) Date of publication of application: **25.01.2017**
(21) Application number: 15765380.9
(22) Date of filing: 05.02.2015
(51) Int. Cl.: H04B 1/18

(54) **WIRELESS APPARATUS**

(30) Priority: 17.03.2014 JP 2014053070
(71) Applicant: Panasonic Intellectual Property Management Co., Ltd., Osaka 540-6207 (JP)
(72) Inventor: MATSUMOTO, Takayuki, Osaka 540-6207 (JP); HORIIKE, Yoshio, Osaka 540-6207 (JP)
(74) Representative: Schwabe - Sandmair - Marx
(86) International application number: PCT/JP2015/000513
(87) International publication number: WO 2015/141117

(57) **Abstract**

Wireless apparatus (100) includes radiation conductor (101) that radiates an electromagnetic wave including a high-frequency signal, power-limiting circuit (108), and high-frequency IC (106). In addition, power-limiting circuit (108) includes radiation conductor side impedance conversion circuit (102), wireless circuit side impedance conversion circuit (105), radiation conductor side power clipping diode (103), and wireless circuit side power clipping diode (104). In addition, radiation conductor side impedance conversion circuit (102) and wireless circuit side impedance conversion circuit (105) are connected between radiation conductor (101) and high-frequency IC (106). In addition, radiation conductor side power clipping diode (103) and wireless circuit side power clipping diode (104) are connected in parallel between radiation conductor side impedance conversion circuit (102) and wireless circuit side impedance conversion circuit (105).

## Description

### TECHNICAL FIELD

The present invention relates to a wireless apparatus connected to a flow-measuring device that measures a flow rate of an object to be measured.

### BACKGROUND ART

In recent years, automatic meter-reading systems have been introduced that measure an amount of gas, electricity, or tap water used with flow-measuring devices installed in buildings such as houses, and that collect such measurement data by wireless communications. Such an automatic meter-reading system includes a wireless adaptor slave unit attached to a metal housing surface of the flow-measuring device, such as a gas meter, and a wireless master unit for performing wireless communications with the wireless adaptor slave unit and transmitting a communication signal to a central apparatus.

Here, as a general wireless apparatus that includes a wireless adaptor slave unit, a wireless master unit, and the like, a wireless circuit is proposed that prevents a wireless component from being damaged or destroyed by a signal received from a radiation conductor (for example, refer to PTL 1). In the wireless apparatus described in PTL 1, a circuit configured to prevent a signal equal to or greater than a predetermined level received from the radiation conductor from being input into a wireless component side is connected between the radiation conductor and the wireless component.

Here, methods for providing a circuit that limits a signal level that is input from the radiation conductor between the radiation conductor and the wireless component include a method for connecting two diodes in parallel to a signal line. When the signal level that is input from the radiation conductor is larger than a power-limiting level prescribed by power W₁ (= V_{f}²/Z) determined by a voltage V_{f} of this diode and an impedance Z of the circuit, the signal cannot pass through this power-limiting circuit. This prevents the wireless component from being destroyed by setting this power-limiting level lower than absolute maximum rated power of the wireless component.

However, this power-limiting level is uniquely determined by the voltage V_{f} and the impedance Z. Also, since the voltage V_{f} is determined by a characteristic of the diode and variations exist in individual diodes, variations will occur in the voltage V_{f}, resulting in occurrence of certain variations also in the power-limiting level.

### Citation List

### Patent Literature

PTL 1: Unexamined Japanese Patent Publication No. 2004-222285

### SUMMARY OF THE INVENTION

The present invention has been made in view of such a conventional problem, and provides a wireless apparatus including an input power-limiting circuit capable of arbitrarily changing a power level that is input from the radiation conductor.

The wireless apparatus according to the present invention includes a radiation conductor that radiates an electromagnetic wave including a high-frequency signal, a power-limiting circuit, and a high-frequency integrated circuit (IC). The power-limiting circuit includes a radiation conductor side impedance conversion circuit, a wireless circuit side impedance conversion circuit, a radiation conductor side power clipping diode, and a wireless circuit side power clipping diode. Also, the radiation conductor side impedance conversion circuit and the wireless circuit side impedance conversion circuit are connected between the radiation conductor and the high-frequency IC. Furthermore, the radiation conductor side power clipping diode and the wireless circuit side power clipping diode are connected in parallel between the radiation conductor side impedance conversion circuit and the wireless circuit side impedance conversion circuit.

Such a configuration allows the impedance conversion circuits to change impedance of a diode circuit arbitrarily. This makes it possible to arbitrarily switch limiting power of the power-limiting circuit to control power that is input into a wireless component to be equal to or less than the absolute maximum rated power of the wireless component, and to prevent the wireless component from being destroyed.

### BRIEF DESCRIPTION OF DRAWINGS

FIG. 1 is a diagram illustrating a configuration of a wireless apparatus according to a first exemplary embodiment of the present invention.
FIG. 2 is a diagram illustrating an example of installation of the wireless apparatus according to the first exemplary embodiment of the present invention.
FIG. 3 is a diagram illustrating a configuration of a wireless circuit according to a second exemplary embodiment of the present invention.

### DESCRIPTION OF EMBODIMENTS

Exemplary embodiments of the present invention will be described below with reference to the drawings. Note that the present invention is not limited to these exemplary embodiments.

### FIRST EXEMPLARY EMBODIMENT

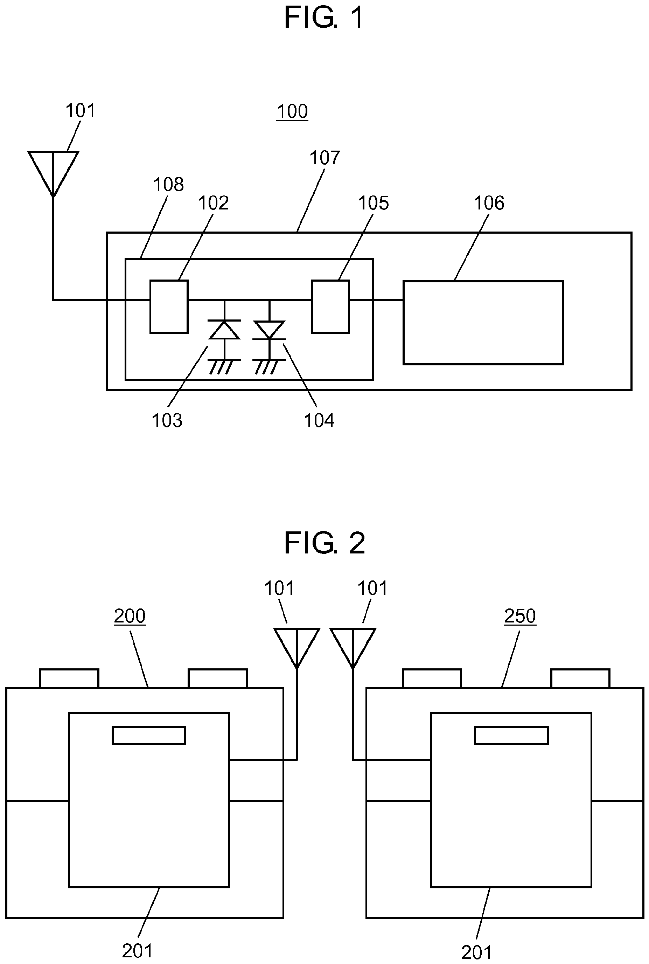

FIG. 1 is a diagram illustrating a configuration of wireless apparatus 100 according to a first exemplary embodiment of the present invention. FIG. 2 is a diagram illustrating an example of installation of wireless apparatus 100 according to the first exemplary embodiment of the present invention.

As illustrated in FIG. 1, wireless apparatus 100 according to the present exemplary embodiment includes radiation conductor 101, power-limiting circuit 108, and high-frequency IC 106. Power-limiting circuit 108 and high-frequency IC 106 are mounted on wireless board 107. In addition, power-limiting circuit 108 includes radiation conductor side impedance conversion circuit 102, wireless circuit side impedance conversion circuit 105, radiation conductor side power clipping diode 103, and wireless circuit side power clipping diode 104.

In FIG. 2, flow-measuring device 200 and flow-measuring device 250 are installed adjacent and in vicinity to each other. Wireless enclosure 201 is installed on a front face of each of flow-measuring device 200 and flow-measuring device 250. Wireless enclosure 201 incorporates wireless board 107.

As illustrated in FIG. 2, it is assumed that flow-measuring device 200 and flow-measuring device 250 are installed in vicinity to each other, and that, for example, flow-measuring device 250 is in a transmission state and flow-measuring device 200 is in a reception state simultaneously. In this case, a high-power transmission signal that is output from radiation conductor 101 on a flow-measuring device 250 side is input into radiation conductor 101 on a flow-measuring device 200 side, and is then input into high-frequency IC 106 on the flow-measuring device 200 side as it is. If there is no power-limiting circuit 108, this high-power signal is input into high-frequency IC 106 as it is. Accordingly, if power of this input signal exceeds absolute maximum rated power of the wireless IC, high-frequency IC 106 is likely to be destroyed.

However, according to the present exemplary embodiment, since wireless apparatus 100 includes power-limiting circuit 108, high power of the input power signal is limited and is input into high-frequency IC 106 as a small power signal, causing no destruction or the like.

Next, power-limiting circuit 108 will be described in detail. In power-limiting circuit 108, radiation conductor side impedance conversion circuit 102 and wireless circuit side impedance conversion circuit 105 are connected outside radiation conductor side power clipping diode 103 and wireless circuit side power clipping diode 104 (on an opposite side of the parallel diode), respectively. That is, radiation conductor side impedance conversion circuit 102 is connected on a radiation conductor 101 side of radiation conductor side power clipping diode 103, and wireless circuit side impedance conversion circuit 105 is connected on a high-frequency IC 106 side of wireless circuit side power clipping diode 104.

Such a configuration can change a circuit impedance of radiation conductor side power clipping diode 103 and wireless circuit side power clipping diode 104, and can adjust a power-limiting level arbitrarily.

For example, it is assumed that there is neither radiation conductor side impedance conversion circuit 102 nor wireless circuit side impedance conversion circuit 105. In this case, if the circuit impedance is 50 Ω, a power-limiting level W₁ can be calculated as W₁ = V_{f}²/50 from a forward voltage V_{f} of the diode and the circuit impedance (50 Ω).

Here, according to the present exemplary embodiment, for example, in order to set the power-limiting level W₁ to 1/2, by adjusting the impedance of radiation conductor side impedance conversion circuit 102 and wireless circuit side impedance conversion circuit 105, the impedance is adjusted from 50 Ω to 100 Ω. Accordingly, a power-limiting level W₂ can be calculated as W₂ = V_{f}²/100 from the forward voltage V_{f} of the diode and the circuit impedance (100 Ω), which indicates that the power-limiting level W₂ becomes half of the power-limiting level W₁ when the circuit impedance is 50 Ω.

As described above, in a case where output from the radiation conductor is high and two or more wireless circuits are installed in vicinity to each other, even if power that is input from radiation conductor 101 exceeds absolute maximum rated power of a wireless component, wireless apparatus 100 according to the present exemplary embodiment can prevent the wireless component from being destroyed.

### SECOND EXEMPLARY EMBODIMENT

Next, a second exemplary embodiment of the present invention will be described.

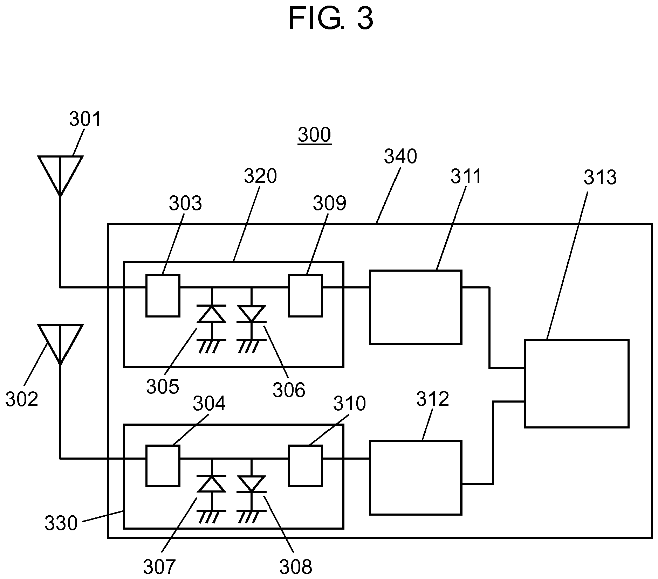

FIG. 3 is a diagram illustrating a configuration of wireless apparatus 300 according to the second exemplary embodiment of the present invention.

As illustrated in FIG. 3, wireless apparatus 300 according to the present exemplary embodiment includes first radiation conductor 301, second radiation conductor 302, first power-limiting circuit 320, second power-limiting circuit 330, first high-frequency IC 311, second high-frequency IC 312, and main microcomputer 313. Among these components, components other than first radiation conductor 301 and second radiation conductor 302 are mounted on wireless board 340. In addition, first power-limiting circuit 320 includes first radiation conductor side impedance conversion circuit 303, first wireless circuit side impedance conversion circuit 309, first radiation conductor side power clipping diode 305, and first wireless circuit side power clipping diode 306.

In addition, second power-limiting circuit 330 includes second radiation conductor side impedance conversion circuit 304, second wireless circuit side impedance conversion circuit 310, second radiation conductor side power clipping diode 307, and second wireless circuit side power clipping diode 308.

Next, first power-limiting circuit 320 will be described in detail. In first power-limiting circuit 320, first radiation conductor side impedance conversion circuit 303 and first wireless circuit side impedance conversion circuit 309 are connected outside first radiation conductor side power clipping diode 305 and first wireless circuit side power clipping diode 306 (on an opposite side of the parallel diode), respectively. That is, first radiation conductor side impedance conversion circuit 303 is connected on a first radiation conductor 301 side of first radiation conductor side power clipping diode 305, and first wireless circuit side impedance conversion circuit 309 is connected on a first high-frequency IC 311 side of first wireless circuit side power clipping diode 306.

Such a configuration can change circuit impedance of first radiation conductor side power clipping diode 305 and first wireless circuit side power clipping diode 306, and can adjust the power-limiting level to first high-frequency IC 311 arbitrarily.

Next, second power-limiting circuit 330 will be described in detail. In second power-limiting circuit 330, second radiation conductor side impedance conversion circuit 304 and second wireless circuit side impedance conversion circuit 310 are connected outside second radiation conductor side power clipping diode 307 and second wireless circuit side power clipping diode 308 (on an opposite side of the parallel diode), respectively. That is, second radiation conductor side impedance conversion circuit 304 is connected on a second radiation conductor 302 side of second radiation conductor side power clipping diode 307, and second wireless circuit side impedance conversion circuit 310 is connected on a second high-frequency IC 312 side of second wireless circuit side power clipping diode 308.

Such a configuration can change circuit impedance of second radiation conductor side power clipping diode 307 and second wireless circuit side power clipping diode 308, and can adjust the power-limiting level to second high-frequency IC 312 arbitrarily.

As illustrated in FIG. 3, it is assumed that first radiation conductor 301 and second radiation conductor 302 are installed in vicinity to each other, and that, for example, first high-frequency IC 311 is in a transmission state and second high-frequency IC 312 is in a reception state simultaneously. At this time, the high-power transmission signal that is output from first radiation conductor 301 is input into second radiation conductor 302. Here, if there is no second power-limiting circuit 330, this high-power signal is input into second high-frequency IC 312 as it is. Accordingly, if power of this input signal exceeds absolute maximum rated power of the wireless IC, second high-frequency IC 312 is likely to be destroyed.

However, according to the present exemplary embodiment, since second power-limiting circuit 330 exists, high power of the input power signal is limited and is input into second high-frequency IC 312 as a small power signal, causing no destruction or the like.

Conversely, if second high-frequency IC 312 is in a transmission state and first high-frequency IC 311 is in a reception state simultaneously, since first power-limiting circuit 320 exists, high power of the input power signal is limited and is input into first high-frequency IC 311 as a small power signal, causing no destruction or the like.

Thus, since a wireless master unit in particular owns a plurality of radiation conductors and is likely to perform transmission and reception simultaneously, the power-limiting circuit of the present exemplary embodiment is effective.

As described above, wireless apparatus 100 according to the first exemplary embodiment includes radiation conductor 101 that radiates an electromagnetic wave including a high-frequency signal, power-limiting circuit 108, and high-frequency IC 106. Power-limiting circuit 108 includes radiation conductor side impedance conversion circuit 102, wireless circuit side impedance conversion circuit 105, radiation conductor side power clipping diode 103, and wireless circuit side power clipping diode 104. In addition, radiation conductor side impedance conversion circuit 102 and wireless circuit side impedance conversion circuit 105 are connected between radiation conductor 101 and high-frequency IC 106. Furthermore, radiation conductor side power clipping diode 103 and wireless circuit side power clipping diode 104 are connected in parallel between radiation conductor side impedance conversion circuit 102 and wireless circuit side impedance conversion circuit 105.

Even in a case where output from the radiation conductor is high and two or more wireless circuits are installed in vicinity to each other, even if power that is input from radiation conductor 101 exceeds absolute maximum rated power of a wireless component, such a configuration can prevent the wireless component from being destroyed.

In addition, wireless apparatus 300 according to the second exemplary embodiment includes first radiation conductor 301 and second radiation conductor 302 that radiate an electromagnetic wave including a high-frequency signal, first power-limiting circuit 320, second power-limiting circuit 330, first high-frequency IC 311, and second high-frequency IC 312. In addition, first power-limiting circuit 320 includes first radiation conductor side impedance conversion circuit 303, first wireless circuit side impedance conversion circuit 309, first radiation conductor side power clipping diode 305, and first wireless circuit side power clipping diode 306. Second power-limiting circuit 330 includes second radiation conductor side impedance conversion circuit 304, second wireless circuit side impedance conversion circuit 310, second radiation conductor side power clipping diode 307, and second wireless circuit side power clipping diode 308. In addition, first radiation conductor side impedance conversion circuit 303 and first wireless circuit side impedance conversion circuit 309 are connected between first radiation conductor 301 and first high-frequency IC 311. First radiation conductor side power clipping diode 305 and first wireless circuit side power clipping diode 306 are connected in parallel between first radiation conductor side impedance conversion circuit 303 and first wireless circuit side impedance conversion circuit 309. Furthermore, second radiation conductor side impedance conversion circuit 304 and second wireless circuit side impedance conversion circuit 310 are connected between second radiation conductor 302 and second high-frequency IC 312. Second radiation conductor side power clipping diode 307 and second wireless circuit side power clipping diode 308 are connected in parallel between second radiation conductor side impedance conversion circuit 304 and second wireless circuit side impedance conversion circuit 310.

Even in a case where output from the radiation conductor is high and two or more wireless circuits are installed in vicinity to each other, even if power that is input from the radiation conductor exceeds absolute maximum rated power of the wireless component, such a configuration can prevent the wireless component from being destroyed.

### INDUSTRIAL APPLICABILITY

As described above, the present invention can produce an exceptional effect of having an input power-limiting circuit that can arbitrarily change the power level that is input from the radiation conductor. Therefore, the present invention is useful as a wireless apparatus connected to a flow-measuring device that measures a flow rate of an object to be measured, in particular, as a wireless apparatus that achieves improvement in strong input characteristics and the like.

### REFERENCE MARKS IN THE DRAWINGS

- 100, 300:: wireless apparatus
- 101:: radiation conductor
- 102:: radiation conductor side impedance conversion circuit
- 103:: radiation conductor side power clipping diode
- 104:: wireless circuit side power clipping diode
- 105:: wireless circuit side impedance conversion circuit
- 106:: high-frequency IC
- 107:: wireless board
- 108:: power-limiting circuit
- 200, 250:: flow-measuring device
- 201:: wireless enclosure
- 301:: first radiation conductor
- 302:: second radiation conductor
- 303:: first radiation conductor side impedance conversion circuit
- 304:: second radiation conductor side impedance conversion circuit
- 305:: first radiation conductor side power clipping diode
- 306:: first wireless circuit side power clipping diode
- 307:: second radiation conductor side power clipping diode
- 308:: second wireless circuit side power clipping diode
- 309:: first wireless circuit side impedance conversion circuit
- 310:: second wireless circuit side impedance conversion circuit
- 311:: first high-frequency IC
- 312:: second high-frequency IC
- 313:: main microcomputer
- 320:: first power-limiting circuit
- 330:: second power-limiting circuit
- 340:: wireless board

## Claims

1. A wireless apparatus comprising:
a radiation conductor that radiates an electromagnetic wave including a high-frequency signal;
a power-limiting circuit; and
a high-frequency integrated circuit (IC),
the power-limiting circuit including:
a radiation conductor side impedance conversion circuit;
a wireless circuit side impedance conversion circuit;
a radiation conductor side power clipping diode; and
a wireless circuit side power clipping diode,
wherein the radiation conductor side impedance conversion circuit and the wireless circuit side impedance conversion circuit are connected between the radiation conductor and the high-frequency IC, and
the radiation conductor side power clipping diode and the wireless circuit side power clipping diode are connected in parallel between the radiation conductor side impedance conversion circuit and the wireless circuit side impedance conversion circuit.

2. A wireless apparatus comprising:
a first radiation conductor that radiates an electromagnetic wave including a high-frequency signal;
a second radiation conductor that radiates an electromagnetic wave including a high-frequency signal;
a first power-limiting circuit;
a second power-limiting circuit;
a first high-frequency IC; and
a second high-frequency IC,
the first power-limiting circuit including:
a first radiation conductor side impedance conversion circuit;
a first wireless circuit side impedance conversion circuit;
a first radiation conductor side power clipping diode; and
a first wireless circuit side power clipping diode,
the second power-limiting circuit including:
a second radiation conductor side impedance conversion circuit;
a second wireless circuit side impedance conversion circuit;
a second radiation conductor side power clipping diode; and
a second wireless circuit side power clipping diode,
wherein the first radiation conductor side impedance conversion circuit and the first wireless circuit side impedance conversion circuit are connected between the first radiation conductor and the first high-frequency IC,
the first radiation conductor side power clipping diode and the first wireless circuit side power clipping diode are connected in parallel between the first radiation conductor side impedance conversion circuit and the first wireless circuit side impedance conversion circuit,
the second radiation conductor side impedance conversion circuit and the second wireless circuit side impedance conversion circuit are connected between the second radiation conductor and the second high-frequency IC, and
the second radiation conductor side power clipping diode and the second wireless circuit side power clipping diode are connected in parallel between the second radiation conductor side impedance conversion circuit and the second wireless circuit side impedance conversion circuit.
